Europäisches Patentamt

European Patent Office

Office européen des brevets

(19)

(11) Publication number: **0 460 469 A1**

## EUROPEAN PATENT APPLICATION

(12)

(21) Application number: 91108457.2

(22) Date of filing: 24.05.91

(51) Int. Cl.⁵: **C08K 7/06, C08J 5/18**

(30) Priority: 25.05.90 US 529089

(43) Date of publication of application:
**11.12.91 Bulletin 91/50**

(84) Designated Contracting States:
**AT BE CH DE DK ES FR GB GR IT LI LU NL SE**

(71) Applicant: **W.R. Grace & Co.-Conn.
Grace Plaza, 1114 Ave. of the Americas
New York New York 10036(US)**

(72) Inventor: **Havens, Marvin Russel
206 Hackney Road
Greer, SC 29651(US)**

(74) Representative: **Abitz, Walter, Dr.-Ing. et al
Abitz, Morf, Gritschneder, Freiherr von
Wittgenstein Postfach 86 01 09
W-8000 München 86(DE)**

(54) **Extrudable EMI shielding film.**

(57) Disclosed is a conductive metallized flexible thermoplastic film for packaging static sensitive devices, such as electronic circuit boards. The film may be made by extruding metal fibers or strands together with a thermoplastic polymer. Preferred metal strands are stainless steel. The films may be oriented, heat-shrinkable films. They afford ESD and EMI protection, and are called Type# film.

EP 0 460 469 A1

The present invention is directed to a conductive flexible thermoplastic film or sheet material useful for packaging electronic devices that are sensitive to static electricity. The sheet is formed from an extruded mixture of metal fiber and thermoplastic polymer. The metal fiber provides conductivity so that the polymeric film affords protection from electromagnetic interference (hereinafter EMI), as well as protection from electrostatic discharge (hereinafter ESD). This is referred to in the art as Type3 protection.

BACKGROUND OF THE INVENTION

When two surfaces are brought in contact with each other, a transfer of electrons may occur resulting in a residual static electrical charge when the surfaces are separated. This phenomena is known as triboelectricity. If the surface is composed of a material that is a conductor, the electrons will dissipate quickly thereby eliminating the excess charge. On the other hand, if the surface is composed of a material that is an insulator (a dielectric), the surface charge takes much longer to dissipate. Thermoplastic polymers are typically excellent insulators and thus are unsatisfactory for uses requiring a nature that will dissipate charges. As the polymers accumulate high charges promoting an attraction for dust and dirt, they can discharge to any lower potential body with which they come in contact.

It is well known to impart conductivity to polymers by impregnating with carbon. Such are disclosed in U.S. Patent 4,333,565 to Woods, U.S. Patent 4,719,039 to Leonardi (assigned to Dynamit Nobel of America), and U.S. Patent 4,585,121 to Capelle (assigned to the United States of America as represented by the Secretary of the Navy). A big drawback, however, of carbon loaded materials is that carbon sloughs and contaminates the packaged product.

Several commercially available packaging products are made from laminated metal sheets for electrically shielding electronic components. One of such products is an antistatic shield bag manufactured by Minnesota Mining and Manufacturing Company as described in Yenni et al U.S. Patent No. 4,156,751 and U.S. Patent No. 4,154,344. The envelope disclosed is constructed from a flexible material generally consisting of a laminated sheet material which can be folded upon itself. The envelope outside is a conductive metal layer, such as nickel, which is coated by vapor deposition onto a polymeric carrier insulating sheet. The inner surface of the envelope is an antistatic layer which is bonded to the other side of the carrier sheet. The envelope's outside metal layer can be coated with an ultra thin protective polymeric resin coating to protect it from abrasion. Such an envelope provides a low surface resistivity on its outside metal surface of no greater than $10^4$ ohms/square. The envelope exhibits static dissipation and static shielding for components placed inside. A disadvantage of such a structure is that the ultra thin protective resinous coating can be scratched off, exposing the metal layer to potential abrasion. The static dissipation or static shielding effect is lost in the area where the conductive metallized layer has been abraded. Abrasion of the metallized layer can occur during routine packaging and shipping of such envelopes. Therefore, such envelopes still require some degree of care in handling and shipment in order to protect the sensitive electronic components.

Another problem with metallized sheets is how to adhere the metal to the plastic. For instance, it is known to use vapor deposition of the metal onto the plastic sheet, such as in U.S. Patent Nos. 4,431,711 and 4,407,871 both to Eisfeller (assigned to Ex-Cell-O Corp.), which relate to vacuum deposition of indium on a dielectric substrate. Electrodeposition of the metal is also known, as shown in U.S. Patent No. 4,647,714 to Goto (assigned to Showa Laminate Printing). In U.S. Patent No. 4,457,977 to Walles (assigned to Dow) polystyrene or polyvinylidene chloride is surface sulfonated to make it metal adherable and then dipped into a metallizing bath. Very common, however, is to laminate the metal to the plastic as is shown in the Yenni et al 3M patents, mentioned above, as well as is shown in U.S. Patent No. 4,699,830 to White (assigned to Baxter Travenol Laboratories), U.S. Patent No. 4,424,900 to Petcavich, U.S. Patent Nos. 4,471,872 and 4,496,406, both to Dedow (assigned to General Dynamics), U.S. Patent No. 4,738,882 to Rayford (assigned to Bemis), U.S. Patent No. 3,801,418 to Cornelis (assigned to the Atomic Energy Commission), U.S. Patent No. 4,756,414 to Mott (assigned to Dow), and U.S. Patent No. 3,572,499 to Mondano (assigned to Custom Materials). A variation is shown in UK Published Patent Application No. 2180792, published April 8, 1987 to Sims (assigned to Jiffy Packaging) wherein the metal is in the form of a grid laminated between an antistatic film and a bubble film. Usually, polyurethane adhesive is used to bond the metal to the plastic. However, delamination problems with all these methods occur. Attempts to improve the adhesion of the metal to the polymer have been made. For instance, Published European Application 282094, priority March 12, 1987, published on January 10, 1989 (assigned to Hercules) discloses that in the vacuum deposition of aluminum, improvement in the adhesion of the metal to the polyolefin is achieved by plasma treating the polyolefin at 67-133 Pascals in vacuum and 40 to 80 watts for 6 to 30 seconds. Another attempt to improve bonding of polyolefin to metal is shown in Published European 282917, priority March 20, 1987, published on January 13, 1989 (assigned to Hoechst) which shows adding particulate calcium carbonate to the polyolefin.

Also, Sanyo Trading is the distributor in the United States for a sheet onto which conductive fibers have been calender rolled, which is manufactured by Mishima Paper of Japan and sold under the tradename Oaktec. These films have copper sulfide fibers, carbon fibers, or stainless steel fibers, calender rolled onto polyethylene (hereinafter PE). Mishima is producing the following conductive PE films for ESD and EMI purposes:

| OAKTEC No. | 132 | 142 | 232 | E010 | E020 | E030 | E040 |
|---|---|---|---|---|---|---|---|
| Conductive Fiber | Cu | Cu | CF | SUS | SUS | SUS | SUS |
| Thickness (micron) | 60 | 60 | 60 | 50 | 50 | 50 | 50 |
| S.R. (ohm/sq) | 1E5 | 1E4 | 1E3 | - | - | - | - |
| V.R. (ohm-cm) | - | - | - | 2E-1 | 6E-2 | 2E-2 | 5E-3 |
| Static Decay (sec) | 0.01 | 0.01 | 0.01 | - | - | - | - |
| Static Shield (Class) | 1-2 | 1 | 1 | - | - | - | - |
| EMI Shield (100MHz) | | | | 36 | 40 | >40 | >40 |

## OBJECT OF THE INVENTION

It would be desirable to provide a flexible metal sheet of material which could be used to create packaging for static sensitive electrical components and/or affording EMI protection. It would be desirable that such a flexible metal sheet material be transparent and capable of being sealed upon itself. Additionally, it would be desirable if the material could be made in a heat-shrinkable version. It would also be desirable to have a flexible metal sheet material which would provide a low surface resistivity on the outer surface and which would obviate the above-mentioned problems of abrasion of the metal layer and/or adhesion of the metal layer to the polymeric layer. Also, when metallized polymeric sheets are folded or crumbled, the metal stress cracks, which problem is obviated by the present extruded film. These and other objects are achieved by the present invention as further described below.

## SUMMARY OF THE INVENTION

The present invention provides a flexible metallized thermoplastic film comprising an extruded thermoplastic polymer in admixture with up to 30 parts by weight of metal fibers.

The present invention also provides this film in heat shrinkable form.

The present invention also provides this film in air cushion form.

The present invention also provides that in a method for making flexible metallized thermoplastic film, the improvement comprising extruding a film of thermoplastic polymer in admixture with up to 30 parts by weight cf metal fibers.

The present invention also provides a packaged static sensitive device protected from electrostatic charges comprising a package of a static sensitive device having conformed thereabout a metallized flexible thermoplastic extruded film of a mixture of thermoplastic polymer and up to about 30 parts by weight of metal fibers.

The present invention also provides a method for protecting wrapped static sensitive devices from electrostatic charges comprising (a) providing a wrap of a metallized flexible thermoplastic extruded film of a mixture of thermoplastic polymer and up to about 30 parts by weight of metal fibers, and (b) conforming said wrap about a selected device.

## DETAILED DESCRIPTION

The flexible polymeric sheet material of the present invention will exhibit a surface resistivity at ambient relative humidity (about 40 to 60% RH) of about $10^{22}$ ohms/square or less. The lower the surface resistivity, the more conductive the material is. More preferably, the material exhibits a surface resistivity of about $10^{10}$ ohms/square or less. Even more preferably, the surface resistivity is no greater than about $10^8$ ohms/square. Highly conductive material of the preferred embodiment will exhibit a surface resistivity of about $10^5$ ohms/square or less. In contrast, insulators (also known as dielectrics) exhibit a surface resistivity

3

greater than $10^{12}$ ohms/square.

Manufacture of Films: Typically, in the manufacture of films, a suitable polymer usually in the form of pellets or the like, is brought into a heated area where the polymer feed is melted and heated to its extrusion temperature and extruded as a tubular "blown bubble" through an annular die. Other methods, such as "slot die" extrusion wherein the resultant extrudate is in planar, as opposed to tubular, form are also well known. If heat shrinkable film is desired, then after extrusion, the film is typically cooled and then reheated and stretched, i.e. oriented by "tenter framing" or by inflating with a "trapped bubble", to impart the heat-shrinkable property to the film, as is further described below. If desired, high energy irradiation, typically via an electron beam, preferably takes place prior to the stretching for orienting the film. However, for the present invention, such irradiation is not necessary since a very suitable packaging film is obtained without irradiation. Below, first is described the general process for making and orienting film. Then irradiation is described.

The film of this invention may be prepared with conventional methods, effecting, for example, a compounding step in accordance with convention industrial practice, e.g. by means of an extruder. Metal fibers or strands are placed right in the extruder with the polymer pellets during compounding. Preferably, the metal strands are cylindrical in shape and from about 2 to about 20 microns in diameter, more preferably about 5 to about 15 microns, and of a length from about 1 millimeter to about 10 millimeters, more preferably about 2 millimeters to about 5 millimeters. Based on the weight amount of polymer, it is preferred that the metal strands be present in a part by weight amount up to about 30, more preferably up to about 20, even more preferably up to about 10. Very suitable fibers, of stainless steel, are supplied by Bekaert and described in their sales brochure entitled "Bekishield® GR Stainless Steel Fiber Grains for Electrically Conductive Plastics".

Film may be formed from an extruded tube by using a "trapped bubble" technique commonly known as the "hot blown" technique. In forming a hot blown film, the tube is not cooled initially after extrusion or coextrusion but rather is first stretched by a hot blown bubble essentially immediately after extrusion while the tube is still at an elevated temperature above the orientation temperature range of the material. Thereafter, the film is cooled, by well-known methods. Those of skill in the art are well familiar with this process and the fact that the resulting film has substantially unoriented characteristics. Other methods for forming unoriented films are well known. Exemplary, is the method of cast extrusion or cast coextrusion which, likewise, is well known to those in the art.

If heat shrinkable material is desired, the stretching for orientation may be conducted at some point during the cool down and while the film is still hot and within its orientation temperature range followed by completing the cooling. Alternatively, after the post extrusion cooling, the relatively thick "tape" extrudate is then reheated to a temperature within its orientation temperature range and stretched to orient or align the crystallites and/or molecules of the material and then cooled. The orientation temperature range for a given material or materials will vary with the different resinous polymers and/or blends thereof which comprise the material. However, the orientation temperature range for a given thermoplastic material may generally be stated to be below the crystalline melting point of the material but above the second order transition temperature (sometimes referred to as the glass transition temperature) thereof. Within this temperature range, the material may be effectively oriented. The terms "orientation" or "oriented" are used herein to describe generally the process steps and resultant product characteristics obtained by stretching and immediately cooling a resinous thermoplastic polymeric material which has been heated to a temperature within its orientation temperature range so as to revise the intermolecular configuration of the material by physical alignment of the crystallites and/or molecules of the material to improve certain mechanical properties of the film such as, for example, shrink tension and orientation release stress. Both of these properties may be measured in accordance with ASTM D 2838-81. When the stretching force is applied in one direction uniaxial orientation results. When the stretching force is simultaneously applied in two directions biaxial orientation results. The term oriented is also herein used interchangeably with the term "heat-shrinkable" with these terms designating a material which has been stretched and set by cooling while substantially retaining its stretched dimensions. An oriented (i.e. heat-shrinkable) material will tend to return to its original unstretched (unextended) dimensions when heated to an appropriate elevated temperature.

Whichever film has been made (the non-oriented molecular configuration or the stretch-oriented "heat-shrinkable" molecular configuration), it may then be stored in rolls and utilized to package a wide variety of items. If the material was manufactured by "trapped bubble" techniques the material may still be in tubular form or it may have been slit and opened up to form a sheet of film material. In this regard, the product to be packaged may first be enclosed in the material by heat sealing the film to itself where necessary and appropriate to form a pouch or bag and then inserting the product therein. Alternatively, a sheet of the material may be utilized to overwrap the product. These packaging methods are all well known to those of skill in the art.

If the material is of the heat-shrinkable, i.e. "oriented", type, then after wrapping, the enclosed product may be subjected to elevated temperatures, for example, by passing the enclosed product through a hot air tunnel. This causes the enclosing heat shrinkable film to shrink around the product to produce a tight wrapping that closely conforms to the contour of the product. As stated above, the film sheet or tube may be formed into bags or pouches and thereafter utilized to package a product. In this case, if the film has been formed as a tube it may be preferable first to slit the tubular film to form a film sheet and thereafter form the sheet into bags or pouches. Such bag or pouch forming methods, likewise, are well known to those of skill in the art.

Alternative methods of producing films of this type are known to those in the art. One well-known alternative is the method of forming a multi-layer film by an extrusion or coextrusion process as was discussed above. In extrusion coating a first tubular layer is extruded and thereafter an additional layer or layers is simultaneously or sequentially coated onto the outer surface of the first tubular layer or a successive layer.

The above general outline for manufacturing of films is not meant to be all inclusive since such processes are well known to those in the art. For example, see US Patent Nos. 4,274,900; 4,299,241; 4,194,039; 4,188,443; 4,048,428; 3,555,604; 3,741,253; 3,821,182 and 3,022,543. The disclosures of these patents are generally representative of such processes and are hereby incorporated by reference.

Many other process variations for forming films are well known to those in the art. For example, conventional pressing, thermoforming or laminating techniques (including corona laminating) may be employed. For instance, multiple layers may be first coextruded with additional layers thereafter being laminated thereon, or two multi-layer tubes may be coextruded with one of the tubes thereafter being laminated onto the other.

An "oriented" or "heat-shrinkable" material is defined herein as a material which, when heated to an appropriate temperature above room temperature (for example 96°C), will have a free shrink of about 5% or greater in at least one linear direction. Free shrink may be measured as per ASTM 2732.

As used herein the term "extrusion", "extruded", or "extruding" is intended to include coextrusion, extrusion coating, or combinations thereof, whether by tubular methods, planar methods, or combinations thereof.

Resistivity or resistance measurements may be made in accordance with ASTM D-257, as revised in 1978.

Irradiation, if desired, may be accomplished by the use of high energy electrons, ultra violet radiation, X-rays, gamma rays, beta particles, etc. Preferably, electrons are employed up to about 20 megarads (Mr) dosage level. The irradiation source can be any electron beam generator operating in a range of about 150 kilovolts to about 6 megavolts with power output capable of supplying the desired dosage. The voltage can be adjusted to appropriate levels which may be for example 1,000,000 or 2,000,000 or 3,000,000 or 6,000,000 or higher or lower. Many apparatus for irradiating films are known to those of skill in the art. The irradiation is usually carried out at a dosage between about 1 Mr (10 kilogrey) and about 20 Mr (200 kilogrey), with a preferred dosage range of about 2 Mr (20 kilogrey) to about 12 Mr (120 kilogrey). Irradiation can be carried out conveniently at room temperature, although higher and lower temperatures, for example 0°C to 60°C may be employed.

It is also generally well known in the art that irradiation, such as by electron beam irradiation, of certain polymeric film materials generally results in a material having improved heat shrink properties, abuse resistance, structural integrity, tensile strength, puncture resistance, and/or delamination resistance. Such physical toughness improvements from irradiation, are discussed in US Patent 3,022,543 (1962) to Baird et al, US Patent 4,178,401 (1979) to Weinberg and US Patent 3,741,253 to Brax et al.

The film may be fashioned to have cushioning characteristics by using bubble cap (also known as air cushioning) machinery, such as that described in US Patents 4,576,669 and 4,579,516, both to Caputo, or that described in US Patents 4,314,865 (February 9, 1982), 4,415,398 (November 15, 1983; divisional of 4,314,865), 4,427,474 (January 24, 1984); Terminal Disclaimer Requiring Expiration on Same Date as 4,314,865), and 4,412,879 (November 1, 1983), all by inventor Ottaviano, or that described in US Patents 3,416,984; 3,405,020; 3,586,565; and 3,785,899, all assigned to Sealed Air, the disclosures of which are incorporated herein by reference, to make a bubble cap laminate which provides cushioning and then the laminate is made into a bag or pouch by conventional methods.

Many polymer resins are suitable for the extruded sheet material. These include, but are not limited to, materials such as polyethylene (PE); polypropylene (PP); ethylene-vinyl acetate (EVA); linear low density polyethylene (LLDPE); high density polyethylene (HDPE), medium density polyethylene (MDPE); low density polyethylene (LDPE); very low density linear polyethylene (VLDPE); ethylene/alkyl-acrylate copolymer (EA1Acr) such as ethylene/butyl acrylate (EBA); ethylene/propylene copolymer (EPC); alpha,beta ethylene unsaturated carboxylic acid copolymer such as ethylene acrylic acid (EAA) or ethylene methacrylic acid (EMAA) and metal salt neutralized copolymers thereof (commonly known under the trademark Surlyn); and the like, the homopolymers, copolymers, terpolymers, etc thereof, and blends and modifications thereof.

Blends of EVA, EPC, EA1Acr, PP, LDPE, HDPE, VLDPE, EAA, EMAA, and LLDPE may also be advantageously employed.

The metal fibers may include but are not limited to metals such as the transition metals for instance nickel, copper, iron, silver, chrome or aluminum and preferably are stainless steel. Fibers of nickel-coated nylon or nickel-coated glass are also useful.

Optionally a quaternary amine (QA) may be mixed in, particularly where the polymers used are a blend of EAA or EMA with LLDPE or EVA, as disclosed in commonly assigned copending U.S.S.N. 143,885 filed January 14, 1988, of which the present inventor is a co-inventor, the disclosure of which is incorporated herein by reference, (counterpart of European Patent Application No. 89100522.5, filed on January 13, 1989, European Published Application No. 0324494 published on July 19, 1989).

The following Examples are intended to illustrate the preferred embodiments of the invention and comparisons thereto. It is not intended to limit the invention thereby.

## MATERIALS EMPLOYED IN THE EXAMPLES

| EVA | MI* | %VA | COMONOMER | SUPPLIER |
|-----|-----|-----|-----------|----------|
| LD318.92 | 2.0 | 9 | Vinyl Acetate | Exxon |

| EAA | MI | % BY WEIGHT ACRYLIC ACID | % BY WEIGHT ETHYLENE | SUPPLIER |
|-----|-----|--------------------------|----------------------|----------|
| PRIMACOR 1410 | 1.5 | 9 | 91 | Dow Chemical |
| PRIMACOR 5981 | 300 | 20 | 80 | Dow Chemical |

| QA | FORMULA | SUPPLIER |
|----|---------|----------|
| Variquat CE-100 | cocoa dimethyl ethyl ammonium ethosulfate | Sherex |

| SS | SUPPLIER |
|----|----------|
| Stainless steel fibers in 25% by wt. sizing resin Sold under trademark Berkishield | Bekaert |

* MI is melt index.

EXAMPLE I

The materials used were as follows:

- Dow Primacor 1410, 5981 resins ("P1410", "P5981")
- Exxon LD318.92 EVA resin ("EVA")
- Sherex Variquat CE-100 ("QUAT"), dimethylethylcocoammonium ethosulfate quat.
- A masterbatch ("WRC-1"), consisting of 25% quat additive and 75% P1410 resin, with the quat additive being dimethylethylcocoammonium ethosulfate.
- Bekaert Bekishield GR75/C10/4 ("SS-4") or GR75/C10/2 ("SS-2"), consisting of bundles of 7 micron diameter pre-chopped stainless steel fibers, 4 mm and 2 mm length, respectively, with 25% by weight of sizing resin.

The procedure was as follows: pellets of resins and stainless steel fiber were dry blended, then fed into a Haake intermeshing counter-rotating twin-screw extruder fitted with a four-inch sheet die and a take-up/calendering device which employed two water-cooled, polished metal rollers. The roller nip pressure was sufficient to render a smooth finish to the films, which otherwise would have had a rough texture due to the stainless steel fibers. Thickness of the resulting films was 12-30 mils. These films were tested for surface resistivity as made, and after pressing them to a final thickness of 6-15 mils (pressing factor of 2) using a heated-platen Carver press.

Resistivity measurements were made using a TREK Model 150 Surface Resistivity Meter. Measurements were made at ambient humidity (about 50% RH), after conditioning for at least 24 hours at room temperature.

One modification of this procedure involved sample 7 below. Here, in addition to resin and steel fiber pellets, a quat ("Sherex") was added. This was accomplished by first coating the resin pellets with molten quat.

Sample composition and surface resistivity results are summarized below.

## SURFACE RESISTIVITY OF RESIN/STEEL FIBER EXTRUDED FILMS

| Sample Number | Composition (parts by wt.) | Surface Resistivity (ohms/square) | |
|---|---|---|---|
| | | Unpressed | Pressed |
| 1 | EVA(95)/SS-4(5) | $>1 \times 10^{12}$ | $1 \times 10^{10}$ |
| 2 | EVA(86)/P5981(9)/SS-2(5) | $>1 \times 10^{12}$ | $1 \times 10^{10}$ |
| 3 | EVA(71)/WRC-1(24)/SS-4(5) | $1 \times 10^{8}$ | $2 \times 10^{8}$ |
| 4 | EVA(76)/P5981(19)/SS-4(5) | $>1 \times 10^{12}$ | $2 \times 10^{10}$ |
| 5 | EVA(71)/P5981(24)/SS-4(5) | $1 \times 10^{11}$ | $8 \times 10^{5}$ |
| 6 | EVA(64)/P5981(31)/SS-4(5) | $>1 \times 10^{12}$ | $2 \times 10^{10}$ |
| 7 | EVA(60)/P5981(30)/QUAT(5) /SS-4(5) | $2 \times 10^{9}$ | $2 \times 10^{9}$ |
| 8 | EVA(62)/P5981(31)/SS-4(7) | $3 \times 10^{10}$ | $8 \times 10^{4}$ |

The interpretation of these results is as follows: Sample 8, having a higher loading of steel fibers than the other samples, showed the most conductivity after pressing. Sample 5 showed good conductivity after pressing as well, possibly a result of reduced fiber breakage and/or better mixing. The reason pressing improved conductivity by several orders of magnitude is believed to be an improvement in steel fiber-steel fiber contact due to alignment. These samples demonstrated a threshold effect in conductor-filled systems, whereby slight increases in loading or alignment (for non-spherical fillers) can lead to very large differences in bulk conductivity as a result of improved contact between filler particles. While it is not intended to be bound to any theory it is postulated that the effect of the resin matrix on the conductivity is believed to be a minor variable compared to fiber loading, degree of dispersion, degree of fiber breakage, and alignment. Samples 3 and 7, which contained quat additive, showed surface resistivities typical of quat-containing films as per S.N. 143885 mentioned above (without any stainless steel fiber). Furthermore, these two samples showed no significant improvement in conductivity due to pressing. Thus, there is no basis for a conclusion about whether or not a synergistic effect exists between the quat/resin matrix and the steel fibers.

EXAMPLE II

Electronic circuit boards are wrapped with the extruded films of Sample 5 and Sample 8 of Example I.

EXAMPLE III

Films are made as per Sample 5 and Sample 8 of Example I, t but these are made by extruding a tube and then stretch orienting 3 times in the transverse direction and 3 times in the longitudinal direction, so that the resultants are heat shrinkable films having an overall biaxial orientation ratio of 9:1. Electronic circuit boards are shrink wrapped with these films.

## Claims

1. A flexible metallized thermoplastic extruded film comprising a thermoplastic polymer in admixture with up to about 30 parts by weight of metal fibers.

2. The film of claim 1 wherein the metal fibers are cylindrical in shape and from about 2 microns to about 20 microns in diameter and from about 1 millimeter to about 10 millimeters in length.

3. The film of claim 1 wherein the metal fibers are selected from nickel, chrome, silver, copper, iron, or aluminum.

4. The film of claim 1 wherein said film exhibits a surface resistivity of about $10^{12}$ ohms/square or less.

5. The film of claim 1 wherein said film is heat shrinkable.

6. The film of claim 1 wherein said film is in air cushion form.

7. In a method for making flexible metallized thermoplastic film, the improvement comprising extruding a film of a thermoplastic polymer in admixture with up to 30 parts by weight of metal fibers.

8. The method of claim 7 wherein the metal fibers are cylindrical in shape and from about 2 microns to about 20 microns in diameter and from about 1 millimeter to about 10 millimeters in length.

9. The method of claim 7 wherein the metal fibers are selected from nickel, chrome, silver, copper, iron, or aluminum.

10. The method of claim 7 wherein said film exhibits a surface resistivity of about $10^{12}$ ohms/square or less.

11. The method of claim 7 wherein said film is heat shrinkable.

12. The method of claim 7 further including the step of forming said film into air cushion form.

13. A packaged static sensitive device protected from electrostatic charges comprising a package of a static sensitive device having conformed thereabout a metallized flexible thermoplastic extruded film of a mixture of thermoplastic polymer and up to about 30 parts by weight of metal fibers.

14. A method for protecting wrapped static sensitive devices from electrostatic charges comprising (a) providing a wrap of a metallized flexible thermoplastic extruded film of a mixture of thermoplastic polymer and up to about 30 parts by weight of metal fibers, and (b) conforming said wrap about a selected device.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | DATABASE WPIL, AN: 85-021429, Derwent Publication Ltd, London, GB; <br> & JP-A-59215827 (UNITIKA KK) <br> * Abstract * | 1-3,7-9, 13 | C 08 K 7/06 <br> C 08 J 5/18 |
| X | DATABASE WPIL, AN: 87-091189, Derwent Publications Ltd, London, GB; <br> & JP-A-62042499 (NIPPON CARBIDE KOGY KK) <br> * Abstract * | 1-3 | |
| P,X | PATENT ABSTRACTS OF JAPAN vol. 14, no. 386 (C-750)(4329) August 21, 1990 <br> & JP-A-2 142 834 (NIPPON PETROCHEM CO LTD ) May 31, 1990 <br> * abstract * | 1-4,7-10 | |
| A | DE-A-2 932 880 (K. SCHULTE) <br> * page 4, paragraph 2 * * page 5, paragraph 3 - page 6, paragraph 3; claims 1-4 * | 1-3 | |
| A | EP-A-0 333 146 (W.R. GRACE & CO) <br> * page 2, line 8 - page 2, line 17 * * page 3, line 23 - page 3, line 28; claims 1,3-4 * | 1,3,5 | TECHNICAL FIELDS SEARCHED (Int. Cl.5) <br><br> C 08 K <br> C 08 L <br> C 08 J |

The present search report has been drawn up for all claims

| Place of search | Date of completion of search | Examiner |
|---|---|---|
| The Hague | 18 September 91 | FUHR C.K.B. |